# EUROPÄISCHE PATENTSCHRIFT

(11) **EP 1 042 821 B1**
(45) Veröffentlichungstag und Bekanntmachung des Hinweises auf die Patenterteilung: **18.09.2002**
(21) Anmeldenummer: 98965609.5
(22) Anmeldetag: 11.12.1998
(51) Int. Cl.: H01L 39/24, H01B 12/10

(54) **VERFAHREN ZUR HERSTELLUNG EINES BANDFÖRMIGEN MEHRKERNSUPRALEITERS MIT HOCH-Tc-SUPRALEITERMATERIAL UND MIT DEM VERFAHREN HERGESTELLTER SUPRALEITER**
PROCESS FOR PRODUCING A STRIP-SHAPED, MULTI-CORE SUPERCONDUCTOR WITH HIGH-Tc SUPERCONDUCTING MATERIAL AND SUPERCONDUCTOR PRODUCED BY THIS PROCESS
PROCEDE DE PRODUCTION D'UN SUPRACONDUCTEUR EN FORME DE BANDE ET A PLUSIEURS NOYAUX CONSTITUES D'UN MATERIAU SUPRACONDUCTEUR A HAUTE TEMPERATURE CRITIQUE ET SUPRACONDUCTEUR REALISE SELON CE PROCEDE

(30) Priorität: 22.12.1997 DE 19757331
(43) Veröffentlichungstag der Anmeldung: 11.10.2000
(73) Patentinhaber: SIEMENS AKTIENGESELLSCHAFT, 80333 München (DE)
(72) Erfinder: FISCHER, Bernhard, D-91058 Erlangen (DE); HELLDÖRFER, Helmut, D-90411 Nürnberg (DE); KAUTZ, Stefan, D-90607 Rückersdorf (DE); MÜLLER, Jens, D-42897 Remscheid (DE); ROAS, Bernhard, D-89520 Heidenheim (DE)
(74) Vertreter: Patentanwälte Westphal, Mussgnug & Partner
(86) Internationale Anmeldenummer: DE9803651
(87) Internationale Veröffentlichungsnummer: WO99033123

(56) Entgegenhaltungen:
- WO-A-94/00886
- DE-A- 19 621 070
- PATENT ABSTRACTS OF JAPAN vol. 017, no. 022 (E-1307), 14. Januar 1993 -& JP 04 249011 A (HITACHI CABLE LTD), 4. September 1992

## Beschreibung

Die Erfindung bezieht sich auf ein Verfahren zur Herstellung eines bandförmigen Supraleiters mit mehreren Leiterkernen gemäß dem Oberbegriff des Patentanspruches 1. Die Erfindung betrifft ferner einen mit diesem Verfahren hergestellten Supraleiter. Ein entsprechendes Herstellungsverfahren und ein damit hergestellter Supraleiter gehen z.B. aus der Veröffentlichung *"Physica C", Vol. 250, 1995, Seiten 340 bis 348*, der WO 94/00886A1, der JP 04-249011 und der DE 19621070A1 hervor.

Es sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und insbesondere eine Flüssig-Stickstoff (LN₂)-Kühltechnik erlauben. Unter solchen Metalloxidverbindungen fallen insbesondere Cuprate von speziellen Stoffsystemen wie insbesondere von selten-erd-haltigen Basistyp Y-Ba-Cu-O oder der selten-erd-freien Basistypen Bi-Sr-Ca-Cu-O oder (Bi, Pb) -Sr-Ca-Cu-O. Innerhalb einzelner Stoffsysteme wie z.B. der Bi-Cuprate können mehrere supraleitende Hoch-T_{c}-Phasen auftreten, die sich durch die Anzahl der Kupfer-Sauerstoff-Netzebenen bzw. -Schichten innerhalb der kristallinen Einheitszellen unterscheiden und die verschiedene Sprungtemperaturen T_{c} aufweisen.

Mit den bekannten HTS-Materialien wird versucht, langgestreckte Supraleiter in Draht- oder Bandform herzustellen. Ein hierfür als geeignet angesehenes Verfahren ist die sogenannte "Pulver-im-Rohr-Technik", die prinzipiell von der Herstellung von Supraleitern mit dem klassischen metallischen Supraleitermaterial Nb₃Sn her bekannt ist. Entsprechend dieser Technik wird auch zur Herstellung von Leitern aus HTS-Material in eine rohrförmige Umhüllung bzw. in eine Matrix aus einem normalleitenden Material, insbesondere aus Ag oder einer Ag-Legierung, ein im allgemeinen pulverförmiges Vormaterial des HTS-Materials eingebracht, das im allgemeinen noch nicht oder nur zu einem geringen Teil die gewünschte supraleitende Hoch-T_{c}-Phase enthält. Das so zu erhaltende Leitervorprodukt wird anschließend in verschiedenen Verformungsschritten, die gegebenenfalls durch mindestens eine Warmebehandlung bei erhöhter Temperatur unterbrochen sein können, auf die gewünschte Enddimension gebracht. Danach wird das so erhaltene Leiterzwischenprodukt zur Einstellung oder Optimierung seiner supraleitenden Eigenschaften bzw. zur Ausbildung der gewünschten Hoch-T_{c}-Phase mindestens einer Glühbehandlung unterzogen, die gegebenenfalls durch einen weiteren Verformungsschritt unterbrochen sein kann.

Bündelt man in an sich bekannter Weise entsprechende Hoch-T_{c}-Supraleiter oder deren Leitervorprodukte oder deren Leiterzwischenprodukte, so kann man auch Leiter mit mehreren supraleitenden Leiterkernen, sogenannte Mehrkern- oder Multifilamentsupraleiter, erhalten.

Bekannte Mehrkernsupraleiter mit HTS-Material haben bevorzugt eine Bandform. Um diese Form eines entsprechenden Leiterendproduktes zu erhalten, muß gemäß der eingangs genannten Literaturstelle ein Walzprozeß vorgesehen werden. Vor diesem Walzprozeß muß jedoch aus dem Leitervorprodukt ein im allgemeinen zylinderförmiger, vorverformter und vorverdichteter Verbundkörper erstellt werden mit einer im allgemeinen gleichverteilten Anordnung von Leiterkernen über den Querschnitt gesehen. Dieser nachfolgend als Rohleiter bezeichnete Verbundkörper wird dann mittels des im allgemeinen mehrere Walzschritte umfassenden Walzprozesses in die flache Bandform überführt, um so eine für eine hohe Stromtragfähigkeit notwendige Textur, d.h. eine weitgehend parallele Ausrichtung der Kristallebenen der supraleitenden Phase, zu erreichen. Hierzu muß das Vormaterial des Supraleiters insbesondere bei der Umformung des Rohleiters durch den Walzprozeß möglichst stark verdichtet werden.

Es zeigt sich jedoch, daß bei einer derartigen Herstellung eines bandförmigen Mehrkernsupraleiters eine vom Gesamtquerschnitt des Leiters her ungleichmäßige Verteilung der einzelnen Leiterkerne auftritt. Die einzelnen Leiterkerne variieren dabei in Dicke und Breite und führen aufgrund einer unter schiedlichen Verdichtung ihres pulverförmigen Vormaterials zu einer ungleichmäßigen Stromverteilung im Leiterendprodukt. Diese Ungleichmäßigkeit hat in erster Linie ihre Ursache in dem mindestens einen Walzschritt, bei dem üblicherweise Walzenpaare einen Walzspalt mit rechteckigem Walzbereich begrenzen. Dann werden nämlich die Mittelbereiche des Leiters besonders stark gepreßt, während es in den seitlichen Randbereichen kaum zu einer Verdichtung des Vormaterials kommt. D.h., im Leiterendprodukt tragen dann mittlere Leiterkerne einen höheren Strom als äußere (seitliche) Leiterkerne.

Man hat versucht, diese Problematik dadurch zu umgehen, daß man von vornherein ein Leitervorprodukt mit einer Rechteckgestalt vorsieht (vgl. z.B. *EP 0 509 436 A*). Der Aufwand zum Aufbau und zur Verformung eines derart gestalteten Leiters ist jedoch sehr hoch.

Aufgabe der vorliegenden Erfindung ist es, das Verfahren mit den eingangs genannten Merkmalen dahingehend auszugestalten, daß mit ihm ein bandförmiger Mehrkernsupraleiter zu erhalten ist, der insbesondere in seinen seitlichen Randbereichen eine gegenüber bekannten Ausführungsformen verbesserte Stromtragfähigkeit (bzw. kritische Stromdichte) besitzt.

Diese Aufgabe wird erfindungsgemäß dadurch die kennzeichnenden Merkmale des Anspruchs 1 gelöst. Der Rohleiter wird hierzu insbesondere in wenigstens einem Walzschritt in einen Walzspalt zwischen zwei Walzen eingeführt, deren Walzflächen zumindest im Walzbereich jeweils eine konkave, wenigstens annähernd elliptische Kontur beschreiben. Dabei sollte die Abweichung von der Idealform einer Ellipse höchstens so groß sein, daß die Kontur in einem Bereich liegt, der durch zwei konzentrische Ellipsen beschreibbar ist, wobei die äußere Ellipse eine Hauptachse und eine Nebenachse besitzt, die jeweils um 10 % größer sind als die entsprechenden Achsen der eingeschlossenen, inneren Ellipse.

Die mit dieser Ausgestaltung des Verfahrens erreichten Vorteile sind insbesondere darin zu sehen, daß aufgrund der elliptischen Kontur der Walzflächen, die auch als Walzspur bezeichnet wird, eine regelmäßigere Anordnung der einzelnen Leiterkerne und eine größere Breitung der seitlichen Randleiterkerne erreicht wird. Während nämlich der mittlere Bereich des Rohleiters durch die elliptische Walzgeometrie standardmäßig auf eine übliche Dicke gewalzt wird, werden die seitlichen Randbereiche stärker auf geringere Dicken umgeformt. Da im Randbereich jedoch die Anzahl der Leiterkerne niedriger ist, stellt sich so eine verhältnismäßig regelmäßige Geometrie ein. Durch die höhere Verdichtung der Leiterkerne wird dann vorteilhaft insgesamt eine höhere kritische Stromdichte des Leiterendproduktes erreicht. Diese Form der erfindungsgemäßen Walzung hat zudem einen positiven Einfluß auf das sogenannte Aspektverhältnis, d.h. auf den Quotienten aus Dicke und Breite, des Mehrkernleiters.

Als besonders vorteilhaft ist anzusehen, wenn bei mehreren Walzschritten sich die mindestens zwei Walzspalte durch das Verhältnis von Ellipsenhauptachse zu Ellipsennebenachse der elliptischen Kontur ihrer zugeordneten Walzflächen unterscheiden. Auf diese Weise läßt sich eine Anpassung der Konturen an die mit jedem Walzschritt zunehmende Verbreiterung des Rohleiters vornehmen.

Der erfindungsgemäß hergestellte bandförmige Mehrkernsupraleiter hat dann vorteilhaft eine zumindest annähernd elliptische Querschnittsform. Die zulässige Abweichung von der Ellipsenform ist entsprechend der Kontur der Walzflächen.

Weitere vorteilhafte Ausgestaltungen des erfindungsgemäßen Verfahrens und des mit ihm hergestellten Mehrkernsupraleiters gehen aus den jeweils abhängigen Ansprüchen hervor.

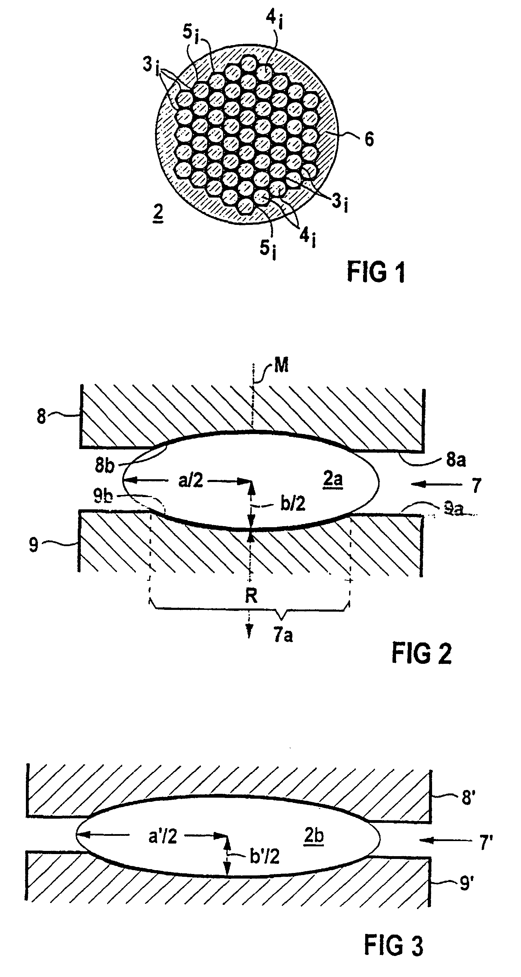

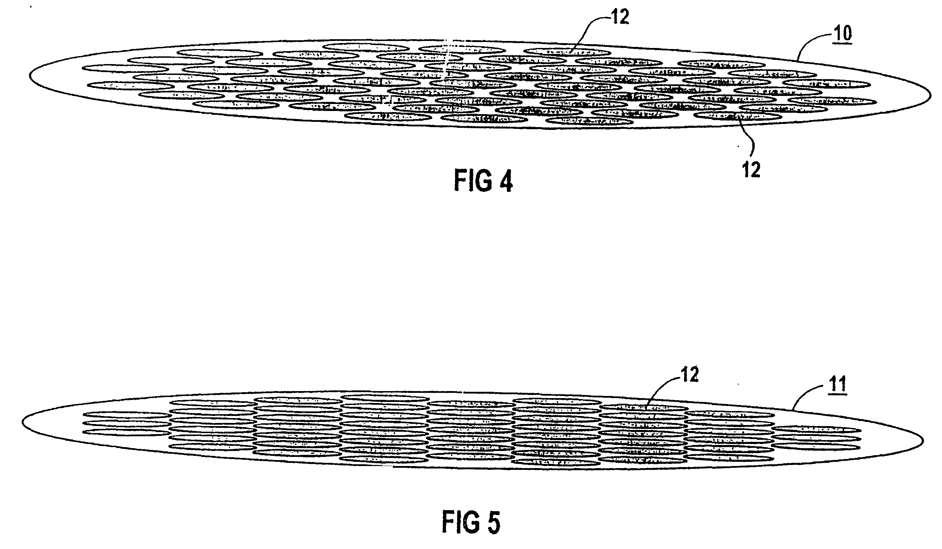

Die Erfindung wird nachfolgend anhand der Zeichnung noch weiter erläutert. Dabei zeigen jeweils schematisch
- deren Figur 1: den Querschnitt eines Rohleiters,
- deren Figur 2: den Querschnitt dieses Rohleiters nach einem ersten erfindungsgemäßen Walzschritt,
- deren Figur 3: den Querschnitt des Rohleiters nach einem weiteren erfindungsgemäßen Walzschritt
und
- deren Figuren 4 und 5: Querschnitte von Leiterendprodukten nach dem erfindungsgemäßen Walzprozeß.

Ein erfindungsgemäß hergestellter, nachfolgend als Leiterendprodukt bezeichneter Mehrkernsupraleiter stellt einen langgestreckten Verbundkörper in Bandform dar, der ein in ein normalleitendes Matrixmaterial eingebettetes Hoch-T_{c}-(HTS)-Supraleitermaterial wenigstens weitgehend phasenrein enthält. Als HTS-Material sind praktisch alle bekannten Hoch-T_{c}-Supraleitermaterialien, vorzugsweise selten-erd-freie, insbesondere Bi-haltige Cuprate, mit Phasen geeignet, deren Sprungtemperatur T_{c} über der Verdampfungstemperatur des flüssigen Stickstoffs (LN₂) von 77 K liegt. Ein entsprechendes Beispiel ist das HTS-Material vom Typ (Bi,Pb)₂Sr₂Ca₂Cu₃Oₓ, das nachfolgend als Ausführungsbeispiel angenommen ist. Zur Herstellung eines entsprechenden HTS-Leiters kann vorteilhaft eine an sich bekannte Pulver-im-Rohr-Technik zugrundegelegt werden (vgl. z.B. *DE 44 44 937 A*). Hierzu wird ein pulverförmiges Vorproduktmaterial, das eine Ausbildung der gewünschten supraleitenden Phase ermöglicht, oder das bereits ausgebildete supraleitende Material in ein erstes Hüllrohr eingebracht, dessen Material als Matrixmaterial für das fertige Endprodukt des Supraleiters dient. Für das Hüllrohr wählt man vorzugsweise ein Basismaterial, das bei der Leiterherstellung keine unerwünschte Reaktion mit den Komponenten des HTS-Materials wie mit Sauerstoff eingeht und das sich leicht verformen läßt. Deshalb ist als Basismaterial besonders ein Ag-Material geeignet, das entweder Ag in reiner Form oder in Form einer Legierung mit Ag als Hauptbestandteil (d.h. zu mehr als 50 Gew.-%) enthält. So ist z.B. reines Ag beispielsweise in Form von kaltverfestigtem Silber oder rekristallisiertem Silber verwendbar. Auch kann pulvermetallurgisch hergestelltes Silber vorgesehen werden. Daneben ist auch dispersionsgehärtetes Silber geeignet.

Der Aufbau aus dem Hüllrohr und dem von ihm umschlossenen Kern z.B. aus dem Vorproduktmaterial des HTS-Materials kann anschließend einer Abfolge von mehreren insbesondere querschnittsvermindernden Verformungsschritten unterzogen werden, um ein Leiterelement mit dem verdichteten Vorproduktmaterial zu erhalten. Für die Verformungsschritte kommen alle bekannten Verfahren wie z.B. Strangpressen, Gesenkschmieden, Hämmern und Ziehen in Frage, die auch miteinander kombiniert sein können. Diese mechanischen Behandlungen können sowohl bei Raumtemperatur als auch bei erhöhter Temperatur durchgeführt werden. Nach diesen Verformungsschritten liegt dann das Leiterelement in Form eines Verbundkörpers mit im allgemeinen kreisförmiger Querschnittsfläche vor.

Um zu einem Mehrkernleiter zu gelangen, wird in bekannter Weise eine Bündelung von mehreren solcher Leiterelemente in einem größeren (zweiten) Hüllrohr insbesondere aus dem Matrixmaterial vorgenommen. Selbstverständlich können auch andere vorgeformte oder gegebenenfalls vorgeglühte Leiter oder Leitervorprodukte in ein solches Hüllrohr eingebracht werden. Der so gewonnene Aufbau kann anschließend noch weiter kompaktiert werden, bevor er einem mindestens einen Walzschritt umfassenden Flachbearbeitungsprozeß unterzogen wird. Mit diesem Flachbearbeitungsprozeß ist eine dem angestrebten Endprodukt zumindest weitgehend entsprechende Bandform zu erhalten. Der vor diesem Flachbearbeitungsprozeß vorliegende Mehrkernaufbau sei nachfolgend als Rohleiter bezeichnet. Dieser Rohleiter muß außer dem Flachbearbeitungsprozeß noch mindestens einer Wärme- oder Glühbehandlung unterzogen werden, die im allgemeinen am Ende des Flachbearbeitungsprozesses vorzugsweise in einer sauerstoffhaltigen Atmosphäre wie z.B. an Luft durchgeführt wird. Auf diese Weise ist dem Vorproduktmaterial der für die Ausbildung der gewünschten supraleitenden Phase erforderliche Sauerstoff zur Verfügung zu stellen oder kann die Wiederherstellung dieser Phase gewährleistet werden.

Im allgemeinen setzt sich der Flachbearbeitungsprozeß aus mehreren Walzschritten zusammen. Dabei kann in einem ersten Walzschritt eine Grobverformung ohne Wärmebehandlung durchgeführt werden. Diesem ersten Walzschritt kann sich dann eine sogenannte thermomechanische Behandlung anschließen. Unter einer solchen Behandlung wird eine Abfolge von weiteren Walzschritten mit Zwischenglühungen zwischen diesen Schritten und die erforderliche Abschlußglühung verstanden. Gemäß der Erfindung soll wenigstens einer dieser Walzschritte, vorzugsweise mindestens der letzte Walzschritt, insbesondere aber alle Walzschritte mit Walzpaaren einer an sich bekannten Walzanlage vorgenommen werden, deren Walzen erfindungsgemäß Walzflächen aufweisen sollen, die zumindest im Walzbereich (= Erfassungsbereich des Walzgutes) jeweils eine konkave, wenigstens annähernd elliptische Kontur beschreiben. Ein entsprechender Walzprozeß mit zwei Walzschritten sei nachfolgend anhand der Figuren 1 bis 3 skizziert:

Figur 1 zeigt einen an sich bekannten Querschnitt (vgl. z.B. *DE 196 21 070 A*) durch einen erfindungsgemäß zu verformenden Rohleiter 2, der durch eine Bündelungstechnik einer vorbestimmten Anzahl von Leiterelementen aufzubauen ist. Jedes Leiterelement setzt sich dabei aus einem Hüllrohr zusammen, das einen z.B. pulverförmigen Kern aus einem Vormaterial des HTS-Materials umschließt. Die Hüllrohre bilden zusammen mit einer sie umschließenden rohrförmigen Umhüllung eine normalleitende Matrix, in die die Kerne aus dem HTS-Vormaterial eingebettet sind. Gemäß dem dargestellten Ausführungsbeispiel wurde der Rohleiter 2 z.B. aus 61 Leiterelementen 3ᵢ mit Kernen 4ᵢ und Hüllrohren 5ᵢ in einer rohrförmigen Umhüllung 6 durch Bündelungstechnik und Querschnittsverminderung und Kompaktierung des Aufbaus erstellt. In der Figur sind der besseren Übersicht wegen die Umrisse der einzelnen Hüllrohre veranschaulicht, obwohl diese bei der Verformung der Leiterelemente zu dem Rohleiter praktisch nicht mehr erkennbar sind.

Dieser Rohleiter 2 wird dann einem Umformungsprozeß durch Walzen mit mehreren Walzschritten unterzogen. Zumindest der wenigstens eine Walzschritt der thermomechanischen Behandlung kann erfindungsgemäß vorgenommen werden. Vorteilhaft ist es jedoch, wenn bereits der wenigstens eine dieser thermomechanischen Behandlung vorgeschaltete Walzschritt entsprechend durchgeführt wird. Gemäß Figur 2 sei ein solcher Walzschritt angenommen. Die Figur zeigt einen einen Walzspalt 7 begrenzenden Teil von einem Paar von Walzen 8 und 9. Diese Walzen haben dabei eine zylinderförmige Gestalt, wobei ihre äußeren Zylindermantelflächen 8a und 9a keinen durchgehend konstanten Kreisquerschnitt besitzen sollen. Vielmehr soll die Kontur 8b bzw. 9b der Mantelfläche zumindest im Walzbereich 7a konkav, wenigstens annähernd elliptisch so verlaufen, daß sich dort ein zur Mittellinie M des Walzspaltes verjüngender Radius R der Walzen ergibt. Der mit derartigen Walzen 8 und 9 zu einem Leiterzwischenprodukt flach bearbeitete Rohleiter ist in der Figur mit 2a bezeichnet.

Die konkrete Wahl der Größen der Hauptachse a und der Nebenachse b der Konturellipse hängt dabei unter anderem von dem jeweiligen Verformungsgrad und der Querschnittsform des zu walzenden Körpers ab. Dabei kann es gegebenenfalls vorteilhaft sein, wenn man ein Walzgut (bzw. Rohleiter) mit zunächst kreisförmigem Querschnitt wie z.B. den Rohleiter 2 zunächst mit Walzen verformt, deren Konturellipsen ein kleineres Verhältnis a/b haben, während man für einen späteren Walzschritt ein größeres Verhältnis a'/b' vorsieht. Ein entsprechendes Ausführungsbeispiel ist der Zeichnung zugrundegelegt. D.h., bei dem in Figur 3 angedeuteten Walzschritt ist das Verhältnis a'/b' der beiden Ellipsenachsen mit etwa 3,7 größer gewählt als das Verhältnis a/b gemäß Figur 2 mit etwa 2,6. Vorteilhaft sieht man für die beiden Walzschritte folgende Verhältnisse vor: 1,5 ≤ a/b ≤ 10 und a/b < a'/b', vorzugsweise 10 ≤ a'/b' ≤ 25. Selbstverständlich sind insbesondere für mehr als zwei Walzschritte auch andere Bereiche für a/b und a'/b' wählbar (vgl. z.B. auch die schematischen Darstellungen in den Figuren 2 und 3). Das nach einem zweimaligen Walzen aus dem Rohleiter hervorgegangene Leiterzwischenprodukt ist in Figur 3 mit 2b, die Walzen sind mit 8' und 9' sowie der zwischen ihnen ausgebildete Walzspalt mit 7' bezeichnet.

Die Figuren 4 und 5 zeigen mögliche Querschnittsformen von bandförmigen Leiterendprodukten 10 bzw. 11 mit 55 Leiterkernen 12 nach einer Rohleiterumformung und einer thermomechanischen Behandlung, wobei erfindungsgemäße Walzschritte durchgeführt wurden. Die Leiterendprodukte haben dabei etwa jeweils annähernd elliptische Querschnitte, wobei im vorliegenden Fall das Ellipsenachsenverhältnis a/b etwa 11,1 bzw. 12,2 beträgt.

Bei den vorstehend erläuterten Ausführungsbeispielen wurde davon ausgegangen, daß der Walzprozeß aus mindestens zwei Walzschritten besteht, wobei die hierfür erforderlichen Walzenpaare abgesehen von den Einschnürungen in ihrem Mittelbereich gleiche Durchmesser haben. Selbstverständlich können auch die einzelnen Walzschritte mit Walzenpaaren durchgeführt werden, die sich hinsichtlich des Durchmessers ihrer Walzen deutlich unterscheiden.

Darüber hinaus kann auch erst ein Walzschritt mit Walzen mit gerader (nicht-gekrümmter) Kontur der Mantellinie parallel zur Walzenachse vorgenommen werden, beispielsweise vor der thermomechanischen Behandlung. Die sich anschließende thermomechanische Behandlung schließt dann den mindestens einen erfindungsgemäßen Walzschritt ein.

## Patentansprüche

1. Verfahren zur Herstellung eines bandförmigen Supraleiters mit mehreren Leiterkernen, welche ein Supraleitermaterial mit einer metalloxidischen Hoch-T_{c}-Phase aufweisen und von einem normalleitenden Material umgeben sind, bei welchem Verfahren
ein Leitervorprodukt mit von dem normalleitenden Material umgebenen, pulverförmigen Vormaterial des Supraleitermaterials einen Rohleiter bildend hergestellt wird und
dieses Leitervorprodukt einem querschnittsvermindernden, das Vormaterial verdichtenden Verformungsprozeß und einer Glühbehandlung zur Bildung eines Leiterendprodukts des Supraleiters unterzogen wird, wobei
der Verformungsprozeß mindestens einen Schritt zum Flachwalzen des Rohleiters und eine sich daran anschließende thermomechanische Behandlung umfaßt, **dadurch gekennzeichnet,**
**daß** zumindest die thermomechanische Behandlung wenigstens einen Walzschritt mit einem Walzspalt (7, 7') zwischen zwei Walzen (8, 9; 8', 9') umfaßt, deren Walzflächen (8a, 9a) zumindest im Walzbereich (7a) jeweils eine konkave, wenigstens annähernd elliptische Kontur beschreiben, so daß das Leiterendprodukt (10, 11) mit einer annähernd elliptischen Querschnittsform erhalten wird, wobei
Kontur und Querschnittsfläche jeweils in einem Bereich liegen, der durch zwei konzentrische Ellipsen beschreibbar ist, und die äußere Ellipse eine Hauptachse und eine Nebenachse besitzt, die jeweils um 10% größer sind als die entsprechenden Achsen der eingeschlossenen, inneren Ellipse.

2. Verfahren nach Anspruch 1, **dadurch gekennzeichnet, daß** sich mindestens zwei Walzspalte durch das Verhältnis von Ellipsenhauptachse (a) zu Ellipsennebenachse (b) der wenigstens annähernd elliptischen Kontur ihrer zugeordneten Walzflächen (8a, 9a) unterscheiden.

3. Verfahren nach Anspruch 2, **dadurch gekennzeichnet, daß** für einen ersten Walzschritt ein Walzspalt (7) mit einem Verhältnis (a/b) der Ellipsenachsen (a bzw. b) zwischen 1,5 und 10 vorgesehen wird, während für einen weiteren Walzschritt ein Walzspalt (7') mit einem größeren Verhältnis (a'/b') der Ellipsenachsen (a' bzw. b') vorzugsweise zwischen 10 und 25 vorgesehen wird.

4. Verfahren nach einem der vorangehenden Ansprüche, **dadurch gekennzeichnet, daß** zunächst ein Walzschritt mit Walzen mit gerader Kontur ihrer Walzflächen vorgenommen wird und sich daran anschließend mindestens ein Walzschritt mit Walzen mit der annähernd elliptischen Kontur anschließt.

5. Verfahren nach einem der vorangehenden Ansprüche, **dadurch gekennzeichnet, daß** das Leitervorprodukt nach einer Pulver-im-Rohr-Technik erstellt wird und der Rohleiter (2) mit einem Bündel aus solchen Leitervorprodukten erstellt wird.

6. Bandförmiger Mehrkernsupraleiter, hergestellt mit einem Verfahren nach einem der vorangehenden Ansprüche, wobei der Mehrkernsupraleiter ein Ag zumindest enthaltendes Material als normalleitendes Material enthält.

7. Supraleiter nach Anspruch 6, **gekennzeichnet durch** Leiterkerne (12) mit einer Hoch-T_{c}-Phase aus einem supraleitenden Bi-Cuprat.

## Claims

1. Method for the production of a tape-shaped superconductor with a plurality of conductor cores comprising a superconductor material with a high T_{c} metal oxide phase and surrounded by a normal-conducting material, in which method a conductor precursor is produced from a pulverulent precursor of the superconductor material surrounded by the normal-conducting material to form a precursor conductor and this conductor precursor is subjected to a section-reducing forming process compacting the precursor and to an annealing operation in order to form a final superconductor, the forming process including at least one step for flat-rolling the precursor conductor and subsequent thermomechanical treatment, **characterised in that** at least the thermomechanical treatment includes at least one rolling step with a roll gap (7, 7') between two rolls (8, 9; 8', 9'), the roll surfaces (8a, 9a) of which, at least in the rolling region (7a), each describe a concave, at least approximately elliptical contour so as to result in a final conductor (10, 11) with an approximately elliptical cross-sectional shape, the contour and the cross-sectional area each being situated in a region which can be described by two concentric ellipses and the outer ellipse having a major axis and a minor axis which are each 10 % greater than the corresponding axes of the included inner ellipse.

2. Method according to claim 1, **characterised in that** at least two roll gaps differ from one another by the ratio between the major axis (a) and the minor axis (b) of the at least approximately elliptical contour of their associated roll surfaces (8a, 9a).

3. Method according to claim 2, **characterised in that** a roll gap (7) with a ratio (a/b) between the axes (a and b) of the ellipse of between 1.5 and 10 is provided for a first rolling step, while a roll gap (7') with a larger ratio (a'/b') between the axes (a' and b') of the ellipse of preferably between 10 and 25 is provided for a further rolling step.

4. Method according to one of the preceding claims, **characterised in that** a rolling step is first carried out with rolls with surfaces with a straight contour, followed by at least one rolling step with rolls with the approximately elliptical contour.

5. Method according to one of the preceding claims, **characterised in that** the conductor precursor is produced by a powder-in-tube technique and the precursor conductor (2) is produced from a bundle of conductor precursors of this kind.

6. Tape-shaped multi-core superconductor produced by a method according to one of the preceding claims, in which the multi-core superconductor contains a material at least containing Ag as the normal-conducting material.

7. Superconductor according to claim 6, **characterised by** conductor cores (12) with a high T_{c} phase made from a superconducting bismuth cuprate.

## Revendications

1. Procédé pour fabriquer un supraconducteur en forme de bande avec plusieurs noyaux conducteurs qui présentent un matériau supraconducteur avec une phase de température critique élevée d'oxydes métalliques et sont entourés d'un matériau à conduction normale, dans lequel procédé
un produit primaire conducteur avec un matériau primaire, pulvérulent et entouré du matériau à conduction normale, du matériau supraconducteur est fabriqué en tant que formant un conducteur brut, et
pour former un produit final conducteur du supraconducteur, ce produit primaire conducteur est soumis à une opération de déformation comprimant le matériau et réduisant la section transversale et à un frittement de recuit, l'opération de déformation comprenant au moins une étape pour laminer à plat le conducteur brut et un traitement thermomécanique ultérieur,
**caractérisé en ce qu'**
au moins le traitement thermomécanique comprend au moins une étape de laminage avec une emprise (7, 7') entre deux cylindres (8, 9; 8', 9') dont les surfaces de cylindres (8a, 9a) présentent au moins dans la zone de cylindre (7a) à chaque fois un contour concave au moins approximativement elliptique, de sorte que le produit final conducteur (10, 11) est obtenu avec une forme de section transversale approximativement elliptique,
le contour et la surface de la section transversale se trouvant à chaque fois dans une zone qui peut être décrite par deux ellipses concentriques dont l'ellipse extérieure a un grand axe et un petit axe qui à chaque fois sont de 10 % plus grands que les axes correspondants de l'ellipse intérieure inscrite.

2. Procédé selon la revendication 1,
**caractérisé en ce qu'**
au moins deux emprises se différencient par le rapport du grand axe de l'ellipse (a) et du petit axe de l'ellipse (b) du contour au moins approximativement elliptique de leurs surfaces de cylindre (8a, 9a) associées.

3. Procédé selon la revendication 2,
**caractérisé en ce que**
pour une première étape de laminage une emprise (7) est prévue avec un rapport (a/b) des axes de l'ellipse (a ou b) situé entre 1,5 et 10, tandis que pour une autre étape de laminage une emprise (7') est prévue avec un rapport (a'/b') supérieur des axes de l'ellipse (a' ou b'), de préférence situé entre 10 et 25.

4. Procédé selon l'une des revendications précédentes,
**caractérisé en ce qu'**
on réalise d'abord une étape de laminage avec des cylindres avec un contour droit de leurs surfaces de cylindre et aussitôt après suit au moins une étape de laminage avec des cylindres avec un contour approximativement elliptique.

5. Procédé selon l'une des revendications précédentes,
**caractérisé en ce que**
le produit primaire conducteur est réalisé selon une technique de la poudre dans le tube et le conducteur brut (2) est réalisé avec une mise en faisceau de tels produits primaires conducteurs.

6. Supraconducteur à plusieurs noyaux en forme de bande fabriqué avec un procédé selon l'une des revendications précédentes, le supraconducteur à plusieurs noyaux contenant un matériau contenant au moins Ag en tant que matériau à conduction normale.

7. Supraconducteur selon la revendication 6,
**caractérisé par**
des noyaux conducteurs (12) avec une phase température critique élevée fabriqués en un cuprate de Bi supraconducteur.
